# EUROPÄISCHE PATENTANMELDUNG

(11) **EP 1 788 361 A2**
(43) Veröffentlichungstag der Anmeldung: **23.05.2007**
(21) Anmeldenummer: 07003460.8
(22) Anmeldetag: 18.04.2000
(51) Int. Cl.: G01D 5/347, H01L 31/16, H01L 27/144

(54) **Integrierter optoelektronischer Dünnschichtsensor für ein Linear-Verschiebungs-Messsystem**

(30) Priorität: 21.04.1999 DE 19917950
(62) Teilanmeldung aus: 00929380.4
(71) Anmelder: Dr. Johannes Heidenhain GmbH, 83301 Traunreut (DE)
(72) Erfinder: Speckbacher, Peter, 84558 Kirchweidach (DE); Michel, Dieter, 83278 Traunstein (DE)

(57) **Zusammenfassung**

Für einen erfindungsgemäßen Dünnschichtsensor wird nur eine sehr dünne Halbleiterschicht (11.3) benötigt, die auf einem Träger (7) aufgebracht wird. Die Schichtdicke der Halbleiterschicht wird dabei durch die Dicke der Fotodetektoren (2) bestimmt. Der Träger (7) trägt zusätzlich zur Halbleiterschicht (11.3) auch die erforderlichen Teilungsstrukturen (8). Dadurch weisen die Teilungsstrukturen (8) einen nur sehr geringen Abstand von den Fotodetektoren (2) und der Lichtquelle (1) auf. Durch diesen geringen Abstand kann die Abbildungsqualität wesentlich verbessert werden. Es besteht außerdem die Möglichkeit weitere optische Elemente in den Träger (7) zu integrieren.

## Beschreibung

Die Erfindung betrifft einen integrierten optoelektronischen Dünnschichtsensor für ein Messsystem nach Anspruch 1.

Aus der GB 1,504,691 und der korrespondierenden DE 25 11 350 A1 ist ein Messsystem bekannt, bei dem die Verschiebung einer ersten Baugruppe relativ zu einer zweiten Baugruppe ermittelt wird. Dafür sind zwei Gitter vorgesehen, die zueinander einen konstanten Abstand aufweisen und von denen je eines an einer Baugruppe befestigt wird. Wird das zweite Gitter mit divergentem Licht einer Lichtquelle bestrahlt, erzeugt das erste Gitter ein periodisches Abbild des zweiten Gitters, wobei sich dieses Abbild bewegt, wenn zwischen den beiden Baugruppen eine relative Bewegung vorliegt. Weiterhin sind Fotodetektoren vorgesehen, die eine periodische Struktur aufweisen und fest mit der zweiten Baugruppe verbunden sind. Dabei ist das erste ein reflektierendes Gitter und das zweite Gitter und die Fotodetektoren liegen im wesentlichen in einer Ebene. Die Lichtquelle und das zweite Gitter können auch durch eine strukturierte Lichtquelle ersetzt werden, die das gleiche Abbild wie eine herkömmliche Lichtquelle und ein Gitter erzeugen. Die Struktur der Fotodetektoren interagiert mit dem Abbild derart, dass eine periodische Änderung des Ausgabesignals der Fotodetektoren auftritt, wenn zwischen erster und zweiter Baugruppe eine Relativbewegung vorliegt.

Dabei ist von Nachteil, dass die einzelnen Baugruppen diskret und separat realisiert werden. Dadurch ist ein relativ großer Einbauraum für die gesamte Anordnung erforderlich.

Aus der DE 197 01 941 A1 ist bekannt, dass auf der einem Maßstab zugewandten Seite eines lichtdurchlässigen Trägers ein Abtastgitter angeordnet ist. Das Abtastgitter wird von einer Lichtquelle derart bestrahlt, dass ein Abbild des Gitters auf den Maßstab projiziert wird. Auf dem Maßstab befindet sich ein zweites Gitter, welches das Abbild auf einen strukturierten Fotodetektor reflektiert. Dabei sind der lichtdurchlässige Träger für das erste Gitter mit dem Halbleitermaterial, in dem der strukturierte Fotodetektor realisiert ist, miteinander derart verbunden, dass Abtastgitter und Fotodetektor ausschließlich in Messrichtung zueinander versetzt sind, vom Maßstab aber die gleiche Entfernung aufweisen. In einer zweiten Ausführungsform der DE 197 01 941 A1 ist das Abtastgitter auf der dem Maßstab abgewandten Seite des lichtdurchlässigen Trägers angeordnet. Auf der gleichen Seite wie das Abtastgitter ist ein Optochip auf dem gleichen lichtdurchlässigen Träger angeordnet, welches den Fotodetektor beinhaltet. Auch durch diese Anordnungen wird erreicht, dass Abtastgitter und strukturierter Fotodetektor ungefähr den gleichen Abstand vom Maßstab aufweisen.

Bei der ersten Ausführungsform besteht der Nachteil, dass der lichtdurchlässige Träger, auf dem das Abtastgitter aufgebracht ist, mit dem Halbleitermaterial, in dem der strukturierte Fotodetektor realisiert ist, verbunden werden muss. Diese Verbindung muss sehr genau erfolgen, so dass die Struktur des Fotodetektors parallel zum Gitter ausgerichtet ist und Struktur und Gitter den gleichen Abstand vom Maßstab aufweisen. Diese exakte Verbindung zwischen Träger und Halbleitermaterial ist daher sehr schwierig zu realisieren. Weiterhin weist die zweite Ausführungsform den Nachteil auf, dass ein Optochip auf dem lichtdurchlässigen Träger befestigt werden muss. Durch die Befestigung in Chip-on-Glass Technologie entsteht zwangsläufig ein Abstand zwischen dem Optochip und dem Träger, wodurch der Abstand zwischen Sendegitter und Maßstab sowie zwischen Fotodetektor und Maßstab wesentlich voneinander abweichen, was zu einer deutlichen Verschlechterung der optischen Eigenschaften der Anordnung führt.

Aus der DE 40 91 517 T1 ist bekannt, einen Sensor für ein Messsystem aus einem einzigen Block aus Halbleitermaterial zu realisieren. Dabei sind auf der Oberfläche einer flächig ausgestalteten Leuchtdiode als Gitterlinien ausgestaltete Fotoelemente vorgesehen, durch welche die Leuchtdiode nicht hindurchstrahlen kann. Dadurch entsteht ein strukturierter Fotodetektor, über bzw. unter dem eine strukturierte Lichtquelle angeordnet ist.

Dieser Sensor weist den Nachteil auf, dass die Fotodetektorstruktur und die strukturierte Lichtquelle zwangsläufig nicht den gleichen Abstand zu einem Maßstab aufweisen können, da Leuchtdiode und Fotodetektor übereinander realisiert werden. Dieser unterschiedliche Abstand zum Maßstab verschlechtert wiederum die optischen Eigenschaften des Sensors deutlich.

Aus der EP 543 513 A1 ist bekannt, dass auf einem gemeinsamen Halbleiterschicht aus III/V-Halbleitermaterial, wie beispielsweise Gallium-Arsenid GaAs, sowohl ein strukturierter Fotodetektor als auch eine strukturierte Lichtquelle in Form von mindestens einer Leuchtdiode eines Sensors realisiert werden. Durch diese Realisierung der strukturierten Lichtquelle und des strukturierten Fotodetektors auf einem gemeinsamen Halbleitermaterial kann die Forderung, dass die Sende- und Empfangsstrukturierung möglichst in einer Ebene zu realisieren ist, sehr gut erfüllt werden. Weiterhin erfolgt eine Einfeldabtastung, bei der die Fotoelemente um 90° + k* 360°, mit ganzzahligem k, versetzt sind. Es werden also mehrere Fotoelemente um neunzig Winkelgrad plus ganzzahlige Vielfache von dreihundertsechzig Winkelgrad in Messrichtung zueinander versetzt angeordnet. Dadurch wird die Abtastung besonders störunempfindlich.

Dabei ist von Nachteil, dass nicht beschrieben wird, wie die Herstellung des strukturierten Fotodetektors und der strukturierten Lichtquelle auf einem gemeinsamen Halbleitermaterial aus GaAs erfolgt. Werden aus dem Stand der Technik bekannte Technologien der Halbleiterherstellung angewandt, so ist dieser Herstellungsprozess sehr aufwendig und damit teuer.

Aus der EP 720 005 A2 ist ein optischer Sensor für ein Messsystem bekannt, der ein Licht emittierendes Bauteil, ein Licht empfangendes Bauteil, und mindestens ein optisches Bauteil aufweist, das auf das vom Licht emittierenden Bauteil gesendeten Lichtstrahl einwirkt, bevor dieser das Licht empfangende Bauteil erreicht. Dieser Sensor weist ein Abstandselement auf, welches einen Abstand zwischen dem Licht emittierenden bzw. dem Licht empfangenden Bauteil und dem optischen Bauteil definiert. Dabei ist das Abstandselement derart ausgestaltet, dass es mit einem anderen Bauteil verbunden wird. Dadurch wird erreicht, dass der optisch Sensor auf seiner einen Seite optische Signale sendet und empfängt, weshalb optische Bauteile auf dieser Seite angeordnet werden, und auf seiner anderen Seite Leitungen für elektrische Signale aufweist.

Dabei ist von Nachteil, dass das Licht empfangende Bauteil, das Licht emittierende Bauteil, das mindestens eine optische Bauteil und das Abstandselement alle aus separaten Bauteilen bestehen, die separat gefertigt und zusammengebaut werden müssen. Dies ist bei den geforderten Genauigkeiten für optische Sensoren von Messsystemen sehr teuer. Weiterhin ist der optische Sensor relativ voluminös, da die einzelnen Bauteile auch separat gehandhabt werden müssen.

Aus der DE 197 20 300 A1 ist ein elektronisches Hybridbauelement bekannt, bei dem in Chip on Chip Anordnung ein implantiertes Chip auf einem Trägersubstrat angeordnet wird. Dafür weist das Trägersubstrat mindestens eine Kavität auf, in der sich eine elektrische Isolationsschicht mit einer darüber liegenden Metallschicht befindet. Der in die Kavität implantierte Chip wird mit der Metallschicht kontaktiert, wodurch diese als elektrische Leitung verwendet wird. Ist der implantierte Chip eine Leuchtdiode, kann die Metallisierungsschicht auch dazu benutzt werden, deren Strahlung an den Wänden der Kavität zu reflektieren.

Diese Anordnung weist den Nachteil auf, dass sowohl die Strahlungsrichtung der Leuchtdiode als auch deren elektrischen Kontakte auf einer Seite der Halbleiterschicht angeordnet sind bzw. auf dieser einen Seite emittiert werden.

Aus der DE 196 18 593 A1 ist ein strahlungsempfindliches Detektorelement mit einem aktiven Bereich bekannt, wobei sich der aktive Bereich zwischen zwei aneinandergrenzenden Schichtbereichen einer Schichtanordnung mit unterschiedlichen Ladungsträgern ausbildet und innerhalb dessen eine Umwandlung einfallender elektromagnetischer Strahlung in elektrische Signale erfolgt. Dabei ist die Lage des aktiven Bereichs relativ zu den beiden begrenzenden Oberflächen unter Berücksichtigung der Eindringtiefe der Strahlung derart gewählt, dass mindestens zwei Kontaktelemente zum Anschluss des Detektorelements an eine Auswerteschaltung an einer Oberfläche montierbar sind, die gegenüber der strahlungsempfindlichen Oberfläche liegt, auf die die einfallende Strahlung auftrifft. Bei dem Herstellungsverfahren eines solchen Detektorelements werden die folgenden Verfahrensschritte angewendet. Es wird eine Ätzstopschicht in einem definiert dotierten Halbleiterschicht knapp unterhalb einer begrenzenden ersten Oberfläche erzeugt. Dann folgt ein räumlich selektives Wegätzen des unterhalb der Ätzstopschicht vorhandenen Substrats, bis die Ätzstopschicht eine begrenzende zweite Oberfläche bildet. Anschließend wird ein räumlich begrenzter Schichtbereich oberhalb der Ätzstopschicht, der eine unterschiedliche Dotierung als das Halbleiterschicht aufweist, erzeugt und das Detektorelement wird auf einer Seite, die gegenüberliegend zur zweiten Oberfläche ist, mit mindestens zwei Kontaktelementen kontaktiert.

Dabei ist von Nachteil, dass hier lediglich eine Fotodiode offenbart ist, jedoch kein vollständiger optoelektronischer Sensor.

Aus der DE 198 59 670.7 ist ein Abtastkopf für einen Maßstab mit einer Teilung bekannt, wobei der Abtastkopf im wesentlichen aus einer einzigen Halbleiterschicht besteht, das auf der dem Maßstab zugewandten Seite mehrere strukturierte Fotodetektoren aufweist, das weiterhin ein Sackloch aufweist, welches auf der dem Maßstab zugewandten Seite durch ein Sendegitter begrenzt wird. Das Sendegitter wird dabei in einer auf das Halbleiterschicht aufgebrachten Schicht oder durch eine spezielle Ausgestaltung des Prozesses zum Einbringen des Sacklochs realisiert. Weiterhin ist eine Lichtquelle im Sackloch angeordnet, die in Richtung des Sendegitters abstrahlt.

Dabei ist nachteilig, dass zwischen Sendegitter und Lichtquelle ein relativ großer Abstand besteht. Weiterhin von Nachteil ist, dass die Fotodetektoren auf der dem Maßstab zugewandten Seite kontaktiert werden.

Aus der DE 198 59 669.3 ist ein integrierter optoelektronischer Sensor zur Abtastung einer Teilung bekannt. Der Sensor besteht aus einer einzigen Halbleiterschicht, welches auf der von der Teilung abgewandten Seite mehrere Fotodetektoren aufweist. Im Bereich der Fotodetektoren ist das Halbleitermaterial zumindest partiell entfernt, so dass Licht von der der Teilung zugewandten Seite des Sensors in den Licht detektierenden Bereich der Fotodetektoren eindringen kann. Auf der von der Teilung abgewandten Seite weist der Sensor eine Lichtquelle auf, in deren Bereich die gesamte Dicke der lichtundurchlässigen Komponenten des Sensors durchbrochen ist, so dass die Lichtquelle durch den Sensor hindurchstrahlt. Die Halbleiterschicht ist auf der der Teilung zugewandten Seite mit einem transparenten Trägerkörper verbunden, der mindestens eine weitere Teilung aufweist, durch die die Strahlung der Lichtquelle optisch beeinflusst wird.

Dabei ist von Nachteil, dass die auf dem Trägerkörper aufgebrachte mindestens eine Teilung im Bereich der Fotodetektoren relativ weit von den Fotodetektoren und im Bereich der Lichtquelle relativ weit von der Lichtquelle entfernt ist. Dadurch verschlechtern sich die optischen Eigenschaften. Ein weiterer Nachteil besteht darin, dass im Bereich der Fotodetektoren in einem speziellen Verfahrensschritt bei der Herstellung Halbleitermaterial entfernt werden muss.

Es stellt sich daher die Aufgabe, einen integrierten optoelektronischen Sensor anzugeben, bei dem der Abstand zwischen den optischen Gittern und den Fotodioden sowie der Lichtquelle möglichst klein ist. Dabei soll das Herstellungsverfahren für den integrierten optoelektronischen Sensor möglichst kostengünstig sein.

Diese Aufgabe wird durch einen Sensor mit den Merkmalen des Anspruchs 1.

Vorteilhafte Ausführungsformen des erfindungsgemäßen Sensors und des erfindungsgemäßen Verfahrens ergeben sich aus den Merkmalen der jeweils abhängigen Ansprüche.

Der erfindungsgemäße Sensor weist den Vorteil auf, dass die Halbleiterschicht, in der die Fotodetektoren realisiert werden, sehr dünn ausgestaltet ist. Dadurch ist der Abstand zwischen den auf dem Träger aufgebrachten Gittern und den Fotodetektoren sowie der Lichtquelle und den Fotodetektoren sehr klein. Dadurch verbessern sich die optischen Eigenschaften des Sensors. Ein weiterer Vorteil besteht darin, dass kein spezieller Verfahrensschritt erforderlich ist, um im Bereich der Fotodetektoren die Dicke der Halbleiterschicht zu verringern. Die Halbleiterschicht ist bereits so dünn, dass sich die detektierenden Bereiche der Fotodetektoren bis an die Grenze zum Träger erstrecken.

Weitere vorteilhafte Ausgestaltungen sind den jeweils abhängigen Ansprüchen und der Beschreibung zu entnehmen.

Weitere Vorteile sowie Einzelheiten des erfindungsgemäßen Sensors und des erfindungsgemäßen Verfahrens ergeben sich aus der nachfolgenden Beschreibung eines Ausführungsbeispiels anhand der Zeichnungen. Dabei zeigt:
- Figur 1:: einen Schnitt durch einen möglichen erfindungsgemäßen Dünnschichtsensor mit zugehöriger Maßverkörperung,

- Figur 2:: einen Ausschnitt aus Figur 1 mit einer alternativen Realisierung,
- Figur 3:: einen Ausschnitt aus Figur 1 mit einer alternativen Realisierung,
- Figur 4:: einen Ausschnitt aus Figur 1 mit einer alternativen Realisierung,
- Figur 5:: einen Ausschnitt aus Figur 1 mit einer alternativen Realisierung,
- Figur 6:: einen Ausschnitt aus Figur 1 mit einer alternativen Realisierung,
- Figur 7:: einen Schnitt durch einen weiteren möglichen erfindungsgemäßen Dünnschichtsensor mit zugehöriger Maßverkörperung,
- Figur 8:: einen möglichen schematisierten Verfahrensablauf für das erfindungsgemäße Verfahren,
- Figur 9:: einen weiteren möglichen schematisierten Verfahrensablauf für das erfindungsgemäße Verfahren und
- Figur 10:: einen weiteren möglichen schematisierten Verfahrensablauf für das erfindungsgemäße Verfahren.

Der erfindungsgemäße Sensor wird im folgenden anhand eines Ausführungsbeispiels erläutert, das ein Längenmesssystem beinhaltet. Es besteht jedoch die Möglichkeit, ohne wesentliche Änderungen, den erfindungsgemäßen Dünnschichtsensor auch bei einem Winkelmesssystem oder einem zweidimensionalen Messsystem einzusetzen.

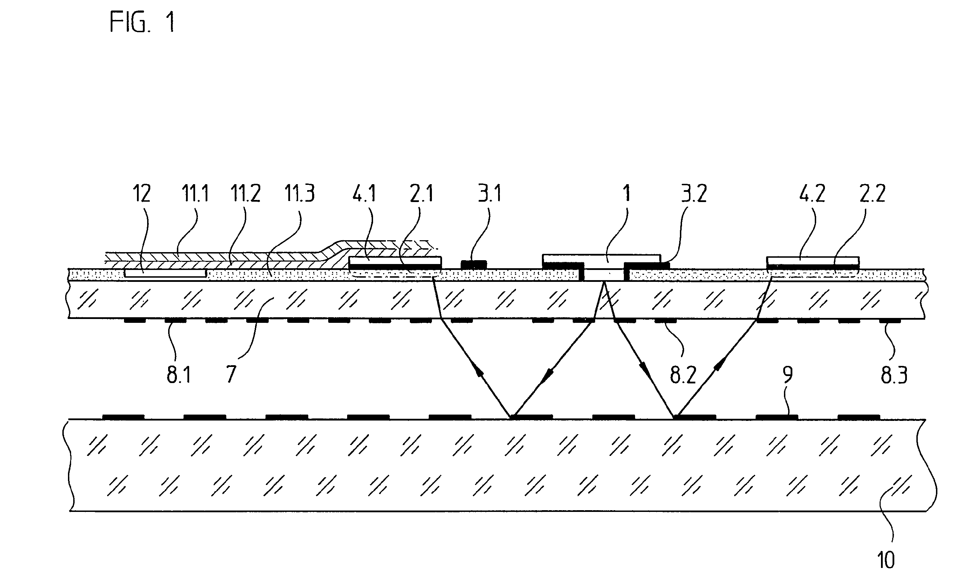

In Figur 1 ist der erfindungsgemäße optoelektronische Dünnschichtsensor und ein Maßstab 10 schematisch dargestellt. Der Dünnschichtsensor besteht aus einer dünnen Halbleiterschicht 11.3, vorzugsweise aus Silizium, in die Fotodetektoren 2.1 und 2.2 integriert sind. Auf der vom Maßstab 10 abgewandten Seite der Halbleiterschicht 11.3 sind Passivierungsschichten 11.1 und 11.2, die aus Siliziumoxid und/oder Siliziumnitrid bestehen, angeordnet. Die Fotodioden 2.1 und 2.2 werden unmittelbar in der Halbleiterschicht 11.3 erzeugt, die den erfindungsgemäßen Dünnschichtsensor bildet. Die beiden Fotodioden 2.1 und 2.2 symbolisieren lediglich mindestens je eine funktionale Baugruppe, die mehrere Fotodioden oder auch mehrere miteinander verschaltete Gruppen von Fotodioden, beispielsweise für eine Einfeldabtastung, beinhalten können. Weiterhin können die Fotodioden 2.1 und 2.2 strukturiert ausgestaltet sein.

Diese funktionalen Baugruppen Fotodioden 2.1 und 2.2 sind symmetrisch zu einer Strahlenquelle 1 für elektromagnetische Strahlung, insbesondere Licht, angeordnet, die bevorzugt durch eine Leuchtdiode 1 realisiert wird. Dabei kann die Leuchtdiode 1 als separates Bauteil mit der Halbleiterschicht 11.3 verbunden werden, wie in der Figur dargestellt. Alternativ können auch in der Halbleiterschicht 11.3 die Fotodioden 2.1 und 2.2 realisiert werden. Dann wird durch entsprechende Dotierung eine Leuchtdiode 1 in einer Halbleiterschicht 11.3 aus geeignetem Halbleitermaterial, beispielsweise Galliumarsenid, hergestellt.

Die Leuchtdiode 1 kann alternativ auch durch einen organischen oder anorganischen Polymerfilm realisiert werden. Dieser wird dann unmittelbar auf den Träger 7 aufgebracht. Die Kontaktierungen 3.2 für die Leuchtdiode 1 sind dann von der vom Maßstab 10 abgewandten Seite der Halbleiterschicht 11.3 zum Polymerfilm hinzuführen.

Vorteilhaft wird jedoch gemäß der Figur für die Leuchtdiode 1 ein separates SMD-Bauteil bevorzugt. Damit die Strahlung der Leuchtdiode 1, die auf der gleichen Seite der Halbleiterschicht 11.3 wie die Fotodioden 2.1 und 2.2 angeordnet ist, auf die andere Seite der Halbleiterschicht 11.3 gelangen kann, wird die Halbleiterschicht 11.3 an dieser Stelle, beispielsweise mittels anisotroper Ätzung, vollständig durchgeätzt.

Weiterhin sind in der vom Maßstab 10 abgewandten Seite der Halbleiterschicht 11.3 weitere elektrische Baugruppen integriert. Neben elektrischen Leitungen 3.1 und Kontaktflächen 3.2 sind auch komplexe Halbleiterschaltungen 12 in dieser gemeinsamen Halbleiterschicht 11.3 integriert. Dabei handelt es sich bevorzugt um rauscharme Verstärker 12 für die Ausgangssignale der Fotodiodenbaugruppen 2.1 und 2.2 sowie um eine Interpolationsbaugruppe 12 für die Ausgangssignale der rauscharmen Verstärker 12.

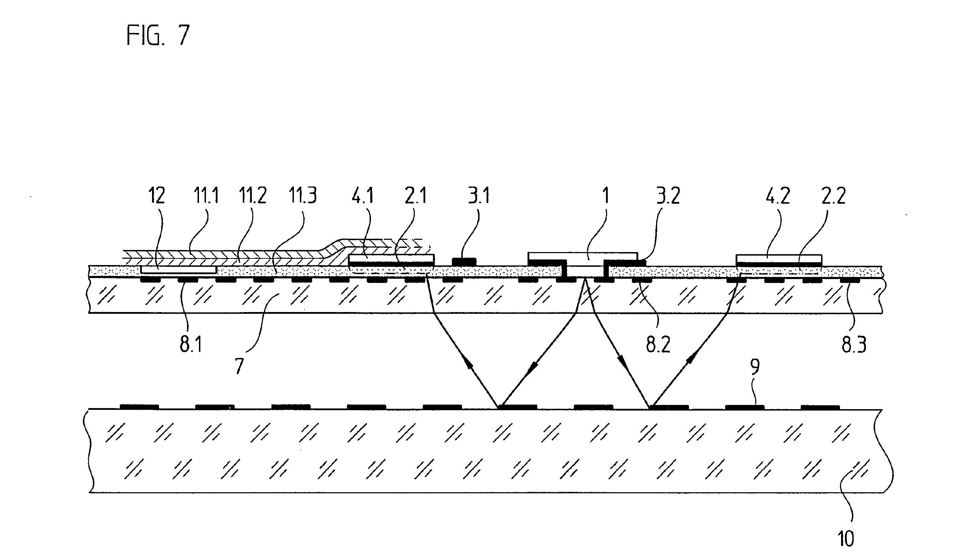

Die Halbleiterschicht 11.3 ist auf der dem Maßstab 10 zugewandten Seite mit einem für die von der Leuchtdiode 1 emittierte Strahlung transparenten Träger 7 verbunden. Diese Verbindung kann durch Kleben, thermisches und/oder anodisches Bonden erreicht werden. Dieser transparente Träger 7 weist eine oder mehrere Teilungen 8.1, 8.2 und 8.3 auf, deren genaue Struktur und Gitterkonstante von dem zu realisierenden Messsystem abhängig ist. Diese Teilungen 8.1, 8.2 und 8.3 werden bevorzugt auf der dem Maßstab zugewandten Seite des Trägers 7 aufgebracht, wie in der Figur 1 gezeigt. Alternativ ist eine Anordnung der Teilungen 8.1, 8.2 und 8.3 auch auf der anderen Seite des Trägers 7 möglich, wie in Figur 7 dargestellt. Die Teilungen 8.1, 8.2 und 8.3 können dabei auch in die Oberfläche des Trägers 7 eingebracht werden, wenn vorher entsprechende Vertiefungen im Träger 7 für die Teilungen 8.1, 8.2 und 8.3 vorgesehen wurden, wie dies in Figur 7 dargestellt ist.

Der wie in Figur 1 oder 7 dargestellt aufgebaute optoelektronische Dünnschichtsensor wird gegenüber einem Maßstab 10 angeordnet, der eine Teilung 9 trägt. Sendet die Leuchtdiode 1 ein Lichtbündel in Richtung Maßstab 10, wird dieses Lichtbündel an der Teilung 8.2 erstmals gebeugt, trifft dann auf die Teilung 9 des Maßstabs 10, wird dort wieder gebeugt und an den Teilungen 8.1 und 8.3 erneut gebeugt, bevor das Lichtbündel auf die Fotodioden 2.1 und 2.2 trifft, durch die die Intensität des Lichtbündels erfasst wird. Das Ausgangssignal der Fotodioden 2.1 und 2.2 wird mindestens einem Verstärker 12 und dessen Ausgangssignal mindestens einem Interpolator 12 zugeleitet, wobei all diese Baugruppen in die Halbleiterschicht 11.3 integriert oder separat realisiert werden können.

Um die elektrische Verdrahtung in einer Ebene ausführen zu können, werden die Fotoelemente 2.1 und 2.2 an der Oberfläche der Halbleiterschicht 11.3 auf der vom Maßstab 10 abgewandten Seite ausgeführt, wie in Figur 1 und 7 dargestellt. Die Dicke der aktiven Schicht der Fotodetektoren 2.1 und 2.2 kann je nach Wellenlänge optimiert angepasst werden, z. B. 25 µm Dicke des aktiven Bereichs der Fotodioden 2.1 und 2.2 bei 860 nm Wellenlänge der von der Leuchtdiode 1 abgestrahlten elektromagnetischen Strahlung. Durch diese für die Fotoelemente 2.1 und 2.2 erforderliche Dicke wird die gesamte Dicke der Halbleiterschicht 11.3 bestimmt.

Um eine Erhöhung der Empfindlichkeit der Fotoelemente 2.1 und 2.2 zu erreichen, kann an der Oberfläche der Fotoelemente 2.1 und 2.2, unter der Passivierungsschicht 11.2, ein Reflektor 4.1 und 4.2 aufgebracht werden. Dieser besteht beispielsweise aus Aluminium und wird in Sputtertechnik auf die Fotoelemente 2.1 und 2.2 aufgebracht. Ist dieser Reflektor 4.1 und 4.2 leitend, kann er auch als ein elektrischer Anschluss der Fotodioden 2.1 und 2.2 benutzt werden. Durch den Reflektor 4.1 und 4.2 werden ansonsten austretende Lichtstrahlen nochmals in den aktiven Bereich der Fotodioden 2.1 und 2.2 reflektiert und erhöhen damit den Photostrom. Außerdem ist ein Strukturieren der Kontakte der Fotodioden 2.1 und 2.2 möglich. Dadurch können diese über die gesamte Fläche der Fotodioden 2.1 und 2.2 verteilt werden. Hierfür weisen die Kontakte eine mäanderförmige oder fingerförmige Struktur auf. Dies bewirkt eine örtlich homogene Empfindlichkeit über die gesamte Fläche der Fotoelemente 2.1 und 2.2.

Zusätzlich kann die dem Lichteintritt zugewandte Seite, also die Unterseite des Trägers 7, durch zusätzliche Schichten aus SiO2 und/oder Si₃N₄ entspiegelt werden. Die Schichtdicke dieser Entspiegelungsschicht wird dabei abhängig von der Wellenlänge der von der Leuchtdiode 1 ausgesendeten Strahlung gewählt.

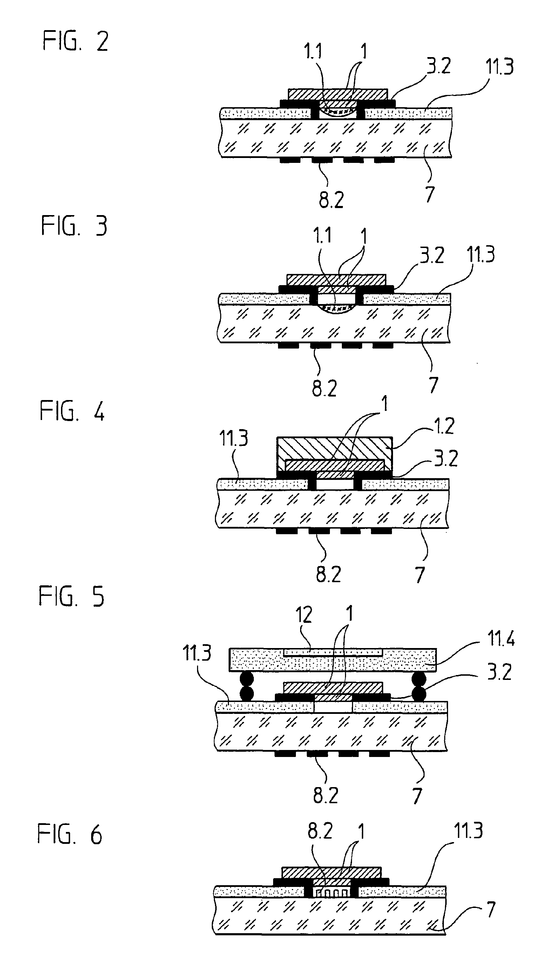

Die Lichtquelle, beispielsweise eine Leuchtdiode 1, wird auf derselben Ebene integriert und elektrisch kontaktiert wie die Fotodioden 2.1 und 2.2 und die Verstärker- und Interpolationseinheit 12, wie in der Figur 1 und 7 dargestellt. Hierzu wird in einem Ätzprozess eine vollständig durchgehende Öffnung in die Halbleiterschicht 11.3 eingebracht. Die Leuchtdiode 1 wird von oben als SMD Element bestückt. Alternativ besteht auch die Möglichkeit einen Trägerkörper 1.2 für die Leuchtdiode 1 vorzusehen, um die Abstrahlebene der Leuchtdiode 1 in der Höhe zu variieren, wie in Figur 4 dargestellt.

Alternativ kann die Leuchtdiode 1 auch auf dem Träger 7 aufgebracht sein und dort kontaktiert werden. Die in die Halbleiterschicht 11.3 eingebrachte Öffnung muss dafür entsprechend groß genug sein. Die Leiterbahnen für die Kontaktierung der Leuchtdiode sind dann entweder vollständig auf dem Träger 7 angeordnet oder sie verlaufen zunächst auf der dem Maßstab 10 abgewandten Seite der Halbleiterschicht 11.3, dann senkrecht dazu entlang der Dicke der Halbleiterschicht bis auf den Träger 10, um die dort angeordnete Leuchtdiode 1 zu kontaktieren.

Eine weitere Alternative zur Realisierung einer Leuchtdiode 1 besteht darin, dass in die Halbleiterschicht 11.3 eine poröse Halbleiterstruktur integriert wird, beispielsweise durch einen anodischen Ätzprozess in Flusssäure. Weiterhin sind entsprechende PN-Übergänge durch Dotierung in den Bereich der porösen Halbleiterstruktur angeordnet, so dass eine Leuchtdiode 1 erzeugt wird.

Als Trägerkörper 1.2 der Leuchtdiode 1 kann ein Gehäuse aus Silizium oder insbesondere Gallium-Arsenid GaAs benutzt werden, wie in Figur 4 dargestellt. Dadurch wird sichergestellt, dass der Trägerkörper 1.2 denselben Ausdehnungskoeffizienten aufweist wie die Leuchtdiode 1, die in der Regel aus GaAs realisiert ist. Bei Verwendung der genannten Materialien als Trägerkörper 1.2 für die Leuchtdiode 1 ist auch gewährleistet, dass aufgrund der guten Wärmeleitfähigkeit des Trägerkörpers 1.2 eine gute Wärmesenke für die Leuchtdiode 1 entsteht. Dies wirkt sich positiv bezüglich der Lebensdauer und Leistung der Leuchtdiode 1 aus. Die Rückseite des Trägerkörpers 1.2 der Leuchtdiode 1 kann durch einen keramischen Schild gegen Wärmeeinstrahlung geschützt werden, ebenso kann dadurch Wärmeabstrahlung verhindert werden.

Der Trägerkörper 1.2 der Leuchtdiode 1 dient gleichzeitig als elektrische Kontaktierung für die SMD Bestückung auf der Oberfläche der Halbleiterschicht 11.3 und für die Kontaktierung der Leuchtdiode 1 selbst. Auf der abstrahlenden Oberfläche der Leuchtdiode 1 kann eine Linse 1.1 aufgebracht werden, um den Strahlengang zu beeinflussen, wie in Figur 2 dargestellt.

Dadurch, dass alle elektrischen Anschlüsse für die Leuchtdiode 1, die Fotoelemente 2.1 und 2.2 sowie die Verstärker- und Interpolationseinheit 12 in einer Ebene liegen, lassen sich die elektrischen Verbindungsleitungen 3.1 zu Verarbeitungsbaugruppen 12 für die Ausgangssignale der optoelektronischen Bauteile 2.1, 2.2 einfach ausführen. Eine bevorzugte Technologie ist ein CMOS kompatibler Technologieprozess zur Integration von Verstärkerund Interpolationseinheit 12.

Die gesamte Oberfläche der Kontaktierungsebene kann mit Passivierungsschichten 11.1 und 11.2 abgedeckt werden, beispielsweise aus SiO₂ und Si₃N₄, die wie die Halbleiterschicht 11.3 ebenfalls gemäß einem CVD Prozess (Chemical vapour deposition) aufgebracht werden.

Bevorzugtes Material für die Halbleiterschicht 11.3 ist Silizium mit einer Kristallorientierung (1-0-0). Auch für eine CMOS Integration der Verstärker- und Interpolationseinheit 12 ist Silizium mit dieser Orientierung zu bevorzugen.

Der Träger 7, welcher an der dem Maßstab 10 zugewandten Seite der Halbleiterschicht 11.3 angeordnet ist, trägt die für die optische Wirkung notwendigen Gitterstrukturen 8.1, 8.2 und 8.3, wie in Figur 1 und 7 symbolisch dargestellt. Die Gitterstrukturen 8.1, 8.2 und 8.3 können als Phasengitter und/oder als Amplitudengitter in Form von Chromgittern ausgeführt werden. Die Gitterstrukturen 8.1, 8.2 und 8.3 werden bevorzugt auf der der Halbleiterschicht 11.3 abgewandten Seite aufgebracht. Möglich ist jedoch auch, dass die Gitterstrukturen 8.1, 8.2 und 8.3 auf der der Halbleiterschicht 11.3 zugewandten Seite des Trägers 7, wie in Figur 7 dargestellt, aufgebracht werden. Dann kann ein Underfiller verwendet werden, um eine optimale Verbindung zwischen Träger 7 und der Halbleiterschicht 11.3 zu erreichen. Um einen Underfiller zu vermeiden, können aber auch zuerst die Gitterstrukturen 8.1, 8.2 und 8.3 auf den Träger 7 und anschließend die Halbleiterschicht 11.3 über die Gitterstrukturen 8.1, 8.2 und 8.3 aufgebracht werden. In einer weiteren Alternative können auch Vertiefungen mit der Dicke der Gitterstrukturen 8.1, 8.2 und 8.3 im Träger 7 vorgesehen werden, in die die Gitterstrukturen 8.1, 8.2 und 8.3 eingebracht werden, so dass der Träger 7 einschließlich der Gitterstrukturen eine plane Oberfläche zum Aufbringen der Halbleiterschicht 11.3 bildet.

Soll die Gitterstruktur 8.2 für die Leuchtdiode 1 auf der vom Maßstab 10 abgewandten Seite des Trägers 7 aufgebracht werden, kann dies dadurch geschehen, dass beim Ätzen der Öffnung für die Leuchtdiode 1 im Bereich des Trägers 7 Stege aus Halbleitermaterial verbleiben, die eine Gitterstruktur 8.2 mit der gewünschten optischen Wirkung bilden, wie dies in Figur 6 dargestellt ist.

In einer alternativen Ausgestaltung kann der Träger 7 sowohl auf seiner dem Maßstab 10 abgewandten Seite als auch dem Maßstab 10 zugewandten Seite jeweils mindestens eine Gitterstruktur aufweisen. Diese mindestens zwei auf beiden Seiten des Trägers 7 aufgebrachten Gitterstrukturen können dabei sowohl als Phasengitter als auch als Amplitudengitter als auch als eine Kombination aus Phasen- und Amplitudengitter realisiert sein. Die Strukturierung des Phasengitters kann dabei nicht nur parallel zu den Gitterlinien der Teilung 9 auf dem Maßstab 10 angeordnet sein, sondern kann auch senkrecht dazu gewählt werden. Durch eine derartige azimuthale Anordnung der Gitterstrukturen werden mehr Bereiche auf der Teilung 9 gleichzeitig abgetastete, wodurch die Verschmutzungsempfindlichkeit verringert wird.

Eine weitere Alternative ist die Einbringung einer optischen Linse 1.1 in den Träger 7 unterhalb der Abstrahlungsebene der Leuchtdiode 1, wie in Figur 3 dargestellt. Aufgrund der Siliziumöffnung kann die Linse 1.1 im Träger 7 auf der dem Maßstab 10 zu- und/oder abgewandten Seite des Trägers 7 aufgebracht werden. Technologisch wird eine solche Linse 1.1 beispielsweise durch Elektronenlithografie in PMMA-Resist erzeugt. Die Wölbung der Linse 1.1 im Resist wird durch unterschiedliche Bestrahlungsdosen im Resist erzeugt, die Resiststruktur wird dann durch Plasmaätzen in den Träger 7 übertragen. Bei dieser Technologie ist es auch möglich, der Linse 1.1 selbst eine Struktur, also z. B. ein Phasengitter 8.2 aufzuprägen. Der Verfahrensschritt zum Einbringen einer optischen Linse 1.1 in den Träger 7 kann auch bereits vor dem Abscheiden der Halbleiterschicht 11.3 erfolgen.

Der Träger 7 kann vorteilhaft aus dem Material Pyrex bestehen, welches denselben Längenausdehnungskoeffizient wie Silizium aufweist. Dies vermindert Spannungen, erhöht die mechanische Stabilität im Silizium und vermeidet damit Versetzungslinien im Silizium, die zu elektrischen Störstellen führen können. Weitere für den Träger 7 geeignete Materialien sind Saphir und geeignete Borsilikatgläser.

Das Messsystem, bei dem der erfindungsgemäße Sensor benutzt wird, kann sowohl ein eindimensionales Messsystem, wie ein Längen- oder Winkelmesssysteme, als auch ein zweidimensionales Messsystem sein, wie ein Kreuzgittermesssystem, das als Maßstab ein Kreuzlinien- oder Schachbrettgitter aufweist. Das dafür erforderliche Abtastsystem weist entweder zwei erfindungsgemäße, vorteilhaft orthogonal zueinander ausgerichtete Sensoren auf. Alternativ können auch in einen Sensor zwei Gruppen von Fotoelementen mit eindimensionaler Strukturierung integriert werden, deren Ausrichtung den Messrichtungen entsprechen oder die orthogonal zueinander stehen. Das Sendegitter wird dann als zweidimensionales Gitter, beispielsweise Kreuzlinien- oder Schachbrettgitter, ausgestaltet und ist dadurch nur einfach erforderlich.

Um einen kompakteren Aufbau des gesamten Sensors zu erreichen, können erfindungsgemäß die weiteren elektronischen Schaltungen 12 auch in einer separaten Halbleiterschicht 11.4 integriert werden, die räumlich über der Halbleiterschicht 11.3 mit den optoelektronischen Baugruppen angeordnet wird, wie dies in Figur 5 dargestellt wird. Da die elektrischen Kontakte erfindungsgemäß bereits ausschließlich auf der Oberseite der Halbleiterschicht 11.3 mit den optoelektronischen Baugruppen angeordnet sind, ist eine Kontaktierung mit der darüber angeordneten Halbleiterschicht 11.4 in Chip on Chip Technologie sehr einfach möglich. Dadurch können die Längen der Verbindungsleitungen zwischen den optoelektronischen und den elektronischen Baugruppen wesentlich verkürzt werden, was zu einer verbesserten Störunempfindlichkeit führt und eine schnellere Signalverarbeitung aufgrund einer höheren Taktrate ermöglicht.

Für den Fachmann ist es offensichtlich, dass die anhand unterschiedlicher Ausführungsbeispiele beschriebenen Merkmale des erfindungsgemäßen Sensors beliebig miteinander kombiniert werden können.

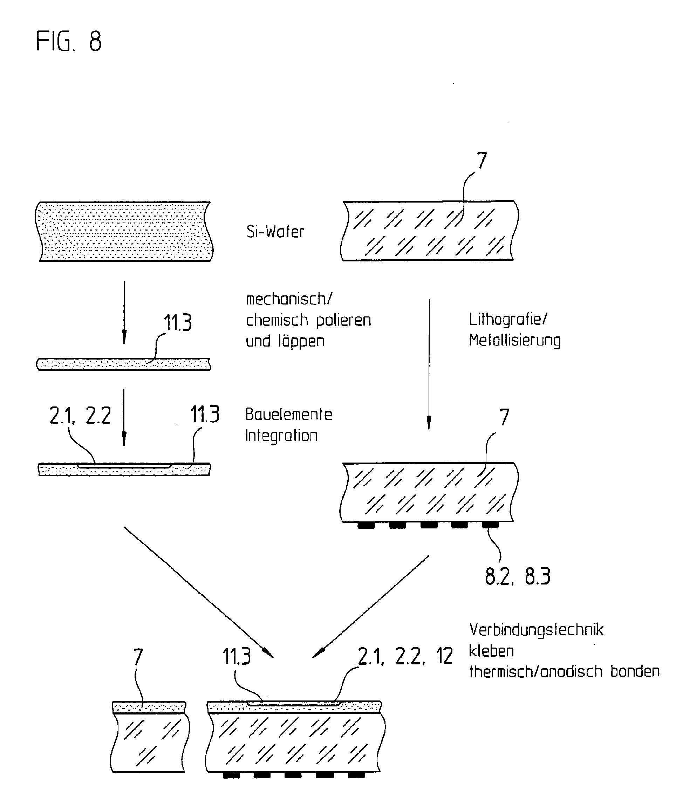

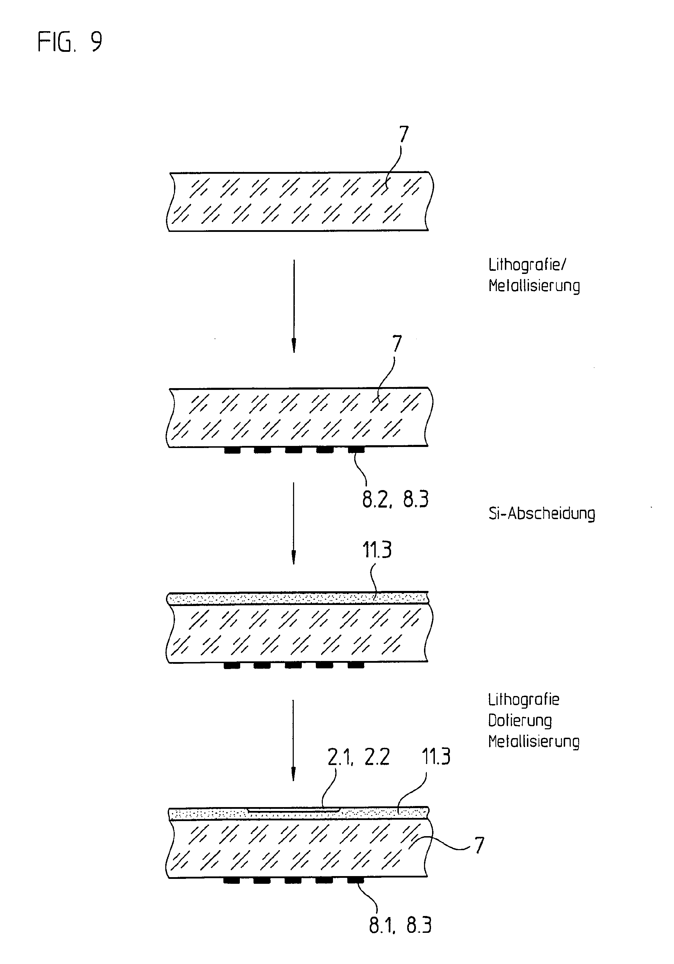

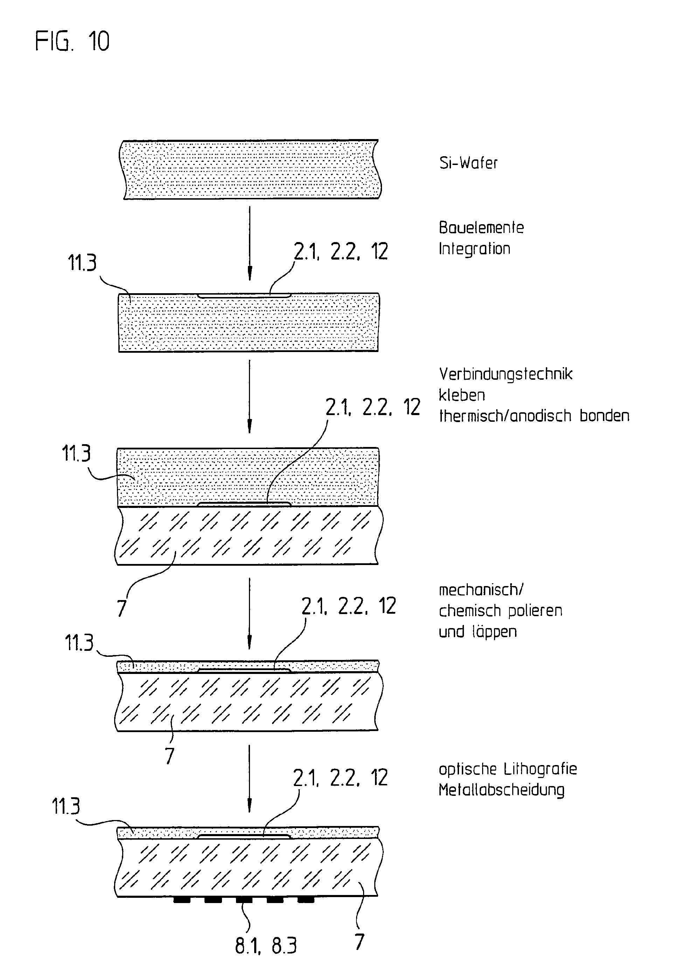

Im folgenden sollen die einzelnen Verfahrensschritte zur Herstellung des erfindungsgemäßen Sensors gemäß den Figuren 8, 9 und 10, die drei unterschiedliche Vorgehensweisen darstellen und die teilweise bereits erwähnt wurden, näher beschrieben werden.

Im wesentlichen gliedert sich das Herstellungsverfahren in die drei Bereiche: Bearbeitung des Trägers 7, Bearbeitung der Halbleiterschicht 11.3 und Verbindung der beiden Teile. Prinzipiell können Träger 7 und Halbleiterschicht 11.3 entweder getrennt voneinander oder wenn diese bereits miteinander verbunden sind bearbeitet werden.

Somit besteht die Möglichkeit, dass zunächst der Träger 7 bearbeitet wird und anschließend entweder die bereits fertig gestellte Halbleiterschicht 11.3 aufgebracht wird oder die Halbleiterschicht nach dem Verbinden mit dem Träger 7 erst noch bearbeitet wird. Alternativ dazu kann auch zuerst die Halbleiterschicht 11.3, eventuell bereits fertig bearbeitet, auf den Träger 7 aufgebracht werden und dann der Träger 7 - und gegebenenfalls die Halbleiterschicht 11.3 - fertig gestellt werden. Die Reihenfolge der Bearbeitung von Träger 7, Halbleiterschicht 11.3 und deren Verbindung miteinander kann im wesentlichen frei gewählt werden, wodurch sich mehrere alternative Verfahrensabläufe ergeben. Es besteht lediglich die Einschränkung, dass nach dem Verbinden der Halbleiterschicht 11.3 mit der vom Maßstab 10 abgewandten Seite des Trägers 7 auf dieser vom Maßstab 10 abgewandten Seite des Trägers 7 keine Gitterstrukturen 8.1, 8.2 und 8.3 mehr aufgebracht werden können.

Bei einem erfindungsgemäßen Verfahren zur Herstellung der Halbleiterschicht 11.3 wird auf der vom Maßstab 10 abgewandten Seite des Trägers 7 Halbleitermaterial, bevorzugt Silizium, in der gewünschten Dicke aufgetragen. Dies kann in einem CVD-Prozess oder anderen aus dem Stand der Technik bekannten Verfahren erfolgen. Dabei wird eine kristalline, polykristalline, amorphe, poröse, mikro- oder nanokristalline Halbleiterschicht 11.3 abgeschieden. Alternativ dazu kann an Stelle des Trägers 7 die Halbleiterschicht 11.3 zunächst auf einem Wafer bearbeitet und erst später mit dem Träger 7 verbunden werden.

In einer weiteren Alternative kann die Halbleiterschicht 11.3 auch aufgesputtert und anschließend mit einem Laser geschmolzen werden, so dass sich nach Erkalten des Halbleitermaterials die benötigte Halbleiterschicht 11.3 ausbildet.

Gemäß einer weiteren Alternative kann Halbleitermaterial durch mechanische Bearbeitung bis zu einer Dicke von ca. 30 µm reduziert und anschließend chemisch geläppt werden. Diese dünne Halbleiterschicht 11.3 wird danach mit dem Träger 7 verbunden, beispielsweise durch Bondverfahren.

In einem zweiten Schritt werden die Fotodioden 2.1 und 2.2 durch entsprechende Dotierung der Bereiche, in denen die Fotodetektoren angeordnet sein sollen, erzeugt. In diesem Schritt kann auch die Erzeugung der weiteren Baugruppen wie Verstärker- und Interpolatoreinheit 12 erfolgen, wenn sie in der gleichen Halbleiterschicht 11.3 vorgesehen sind.

In einem dritten Schritt werden Leiterbahnen 3.1 und Kontaktierungen 3.2, ebenso wie metallische Beschichtungen 4.1 und 4.2 der Rückseiten der Fotodioden 2.1 und 2.2 aufgebracht. Dies erfolgt durch Aufbringen einer Metallisierungsschicht aus Aluminium-Titanoxid, die in bekannten fotochemischen Prozessen entsprechend strukturiert wird, auf die Halbleiterschicht 11.3.

Im nächsten Schritt wird die Leuchtdiode 1, gegebenenfalls in einem Gehäuse aus Halbleitermaterial und mit einem Schild aus Keramik, mit den Kontaktstellen 3.2 elektrisch leitend verbunden. Wird eine polymere Leuchtdiode 1 verwendet, wird diese erst später nach Verbinden des Trägers 7 mit der Halbleiterschicht 11.3 kontaktiert.

Falls die weiteren Baugruppen wie Verstärker- und Interpolatoreinheit 12 nicht neben den optoelektronischen Baugruppen 1, 2.1, 2.2 usw. realisiert werden, kann anschließend eine zusätzliche Halbleiterschicht 11.4, in der die zusätzlichen Baugruppen 12 realisiert sind, von oben mit der Halbleiterschicht 11.3 verbunden werden. Diese Verbindung kann in Chip on Chip Technik ausgeführt werden, so dass die beiden Halbleiterschichten 11.3 und 11.4 elektrisch leitend miteinander verbunden werden.

Bei dem erfindungsgemäßen Verfahren zur Herstellung des Trägers 7 besteht die Möglichkeit, eine Linse 1.1 in den Träger 7 zu integrieren, die das Licht der Leuchtdiode 1 kollimiert. Dafür wird in einem PMMA-Resist eine Vorlage für die Linse mittels Elektronenstrahllithographie geformt. Die Dosis während des Belichtens mit Elektronen wird dabei so verändert, dass sich nach dem Entwicklungsprozess die Form einer optischen Linse 1.1 ergibt. Diese wird, beispielsweise mittels Plasmaätzprozess, ins Material des Trägers 7 übertragen.

Anschließend werden die Gitterstrukturen 8.1, 8.2 und 8.3 auf den Träger 7 aufgebracht. Phasengitter können auf die gleiche Weise wie die soeben für eine Linse beschrieben auf dem Träger 7 erzeugt werden. Amplitudengitter werden nach bekannten Verfahren, beispielsweise als Chromgitter, auf den Träger 7 aufgebracht.

Die Verbindung von Träger 7 und Halbleiterschicht 11.3 kann gemäß den Figuren 8, 9 und 10 zu einem beliebigen Zeitpunkt erfolgen. Vorteilhaft ist die Verbindung durchzuführen, wenn Träger 7 und Halbleiterschicht 11.3 fertig bearbeitet sind, da dann Träger 7 und Halbleiterschicht 11.3 getrennt voneinander bearbeitet werden können, wie in Figur 8 dargestellt. Alternativ dazu kann es vorteilhaft sein, die Halbleiterschicht 11.3 direkt auf dem Träger 7, der sich in einem beliebigen Bearbeitungsstadium befindet, abzuscheiden.

Alternativ besteht die Möglichkeit, nur an den Stellen Halbleitermaterial auf dem Träger 7 abzuscheiden, an denen auch Halbleiterbaugruppen des Sensors vorgesehen sind. Dies wird dadurch erreicht, dass das Halbleitermaterial, wie bereits beschrieben, als Halbleiterschicht 11.3 auf der gesamten vom Maßstab 10 abgewandten Seite des Trägers 7 angeordnet wird und anschließend das nicht benötigte Halbleitermaterial in lithografischen Prozessen wieder entfernt wird. Alternativ dazu kann Halbleitermaterial auch selektiv nur dort auf dem Träger 7 aufgebracht werden, wo auch Halbleiterbaugruppen vorgesehen sind.

Für den Fachmann ist es offensichtlich, dass die angegebenen Verfahrensschritte weitgehend beliebig miteinander kombiniert werden können und dadurch eine Vielzahl von Kombinationsmöglichkeiten für ein Herstellungsverfahren des Sensors ergeben, die hier nicht alle erschöpfend beschrieben werden können.

## Patentansprüche

1. Messsystem, mit einem Maßstab (10), einem dem Maßstab (10) gegenüberliegenden transparenten Träger (7) mit mindestens einer Gitterstruktur (8.1, 8.2, 8.3), sowie einer auf der dem Maßstab (10) abgewandten Seite des Trägers (7) angeordneten und als Dünnschicht ausgebildeten Halbleiterschicht (11.3), wobei
- in der Halbleiterschicht (11.3) mindestens ein Photodetektor (2.1, 2.2) integriert ist,
- über einer Öffnung in der Halbleiterschicht (11.3) eine Leuchtdiode (1) angeordnet ist, die in Richtung des Maßstabes (10) abstrahlt,
- auf der dem Maßstab (10) abgewandten Seite des Trägers (7) und unterhalb der Leuchtdiode (1) eine Gitterstruktur (8.2) ausgebildet ist, die aus Stegen der mittels eines Ätzprozesses strukturierten Halbleiterschicht (11.3) bestehen,
- und wobei die Dicke der Halbleiterschicht (11.3) im wesentlichen der Dicke des detektierenden Bereichs des mindestens einen Photodetektors (2.1, 2.2) entspricht.

2. Messsystem nach Anspruch 1, wobei die Halbleiterschicht (11.3) aus Silizium besteht.

3. Messsystem nach Anspruch 1 oder 2, wobei die Leuchtdiode (1) als SMD - Element ausgebildet ist.

4. Messsystem nach einem der vorhergehenden Ansprüche, wobei mehrere Photodetektoren (2.1, 2.2) symmetrisch zur Lichtquelle (1) angeordnet sind.

5. Messsystem nach einem der vorhergehenden Ansprüche, wobei die Lichtquelle (1) divergent abstrahlt.

6. Messsystem nach einem der vorhergehenden Ansprüche, wobei der Träger (7) einen ähnlichen Ausdehnungskoeffizienten wie die Halbleiterschicht (11.3) aufweist.

7. Messsystem nach einem der vorhergehenden Ansprüche, wobei der Träger (7) aus einem Borsilikatglas oder Saphir besteht.

8. Messsystem nach einem der vorhergehenden Ansprüche, wobei elektrische Leitungen (3.1) und Kontaktierungen (3.2) auf der vom Maßstab (10) abgewandten Seite der Halbleiterschicht (11.3) angeordnet sind.
